Europäisches Patentamt

European Patent Office

Office européen des brevets

(19)

(11) Publication number: **0 303 409**

**A1**

(12) **EUROPEAN PATENT APPLICATION**

(21) Application number: 88307242.3

(51) Int. Cl.⁴: **C30B 15/12**

(22) Date of filing: 05.08.88

(30) Priority: 06.08.87 GB 8718643

(43) Date of publication of application:
15.02.89 Bulletin 89/07

(84) Designated Contracting States:
DE FR IT

(71) Applicant: **UNITED KINGDOM ATOMIC
ENERGY AUTHORITY
11 Charles II Street
London SW1Y 4QP(GB)**

(72) Inventor: **Quarini, Giuseppe Leonardo
Crosswinds Didcot Road
Harwell Oxon(GB)**
Inventor: **Lovegrove, Peter Colin
1 Beaufort Close Fleet Meadow
Didcot Oxon(GB)**
Inventor: **Robertson, James Martin
14, Nuneham Square
Abingdon Oxon(GB)**

(74) Representative: **Mansfield, Peter Turquand
United Kingdom Atomic Energy Authority
Patents Branch 11 Charles II Street
London SW1Y 4QP(GB)**

(54) **Single crystal pulling.**

(57) A method and an apparatus are provided for pulling a single crystal 48, of for example silicon, from molten material 16 in a container 12. The crystal 48 is pulled from a local free surface 60 of the molten material 16 and turbulent convective flow below the local free surface 60 is suppressed. The local free surface 60 may lie within a pressure tube 20, the surface 60 being depressed below the free surface 28 in the container 12 by gas pressure 54. The molten material 16 is heated at its upper surface 28 by electric, or appropriate, heaters 30. Crystals 48 so produced should have fewer residual thermal stresses and a more homogeneous distribution of impurities than crystals pulled by a known method.

Fig.1.

## Single Crystal Pulling

This invention relates to an apparatus and a method for pulling a single crystal, for example of silicon from a crucible of molten silicon.

It is known to pull a crystal of silicon from molten silicon in a heated crucible, the crystal being drawn from the free surface at the top of the molten silicon, but it has been found that thermal stresses may be present in the crystal, and that impurities present in the molten silicon are not distributed homogeneously throughout the crystal.

The present invention provides, in a method for pulling a single crystal from molten material in a container, that the molten material is heated at or near the top thereof, the crystal is pulled from a local free surface of the molten material, and turbulent flow of the molten material is suppressed in the region of the local free surface.

Turbulent flow may be suppressed by arranging the local free surface to be well below the free surface of the molten material in the container. Alternatively, turbulent flow may be suppressed by arranging the depth of molten material below the local free surface to be sufficiently small that laminar flow prevails.

The invention also provides an apparatus for pulling a single crystal from molten material, the apparatus comprising, a container for the molten material, heating means at the upper portion of the container, pulling means for pulling a crystal from a local free surface of the molten material, and means for suppressing turbulent flow in the molten material below the local free surface.

The suppressing means may comprise a member defining an elongate chamber arranged to extend substantially vertically and having an opening to provide communication for the molten material between the chamber and the container below the upper portion of the container, and pressure means for depressing the free surface of the molten material within the chamber well below the level of the free surface of the molten material in the container, the pulling means being arranged to pull a crystal from the depressed free surface.

Preferably, the molten material is heated across the top thereof, and means may be provided to cool the molten material at the bottom portion of the container. The chamber is desirably defined by a tube extending into the container and having an open lower end near the bottom portion of the container. A shroud member may be provided within the chamber to protect at least in part the crystal being pulled from heat radiation from the walls of the chamber. The free surface of the molten material in the chamber may be depressed by gas pressure means, and the gas may be arranged to flow through the chamber. The gas flow is preferably arranged to flow downwardly inside the shroud member over the surface of the crystal being pulled, and upwardly between the shroud and the walls of the chamber, and is desirably adjustable.

An alternative suppressing means comprises a member arranged so as to be immersed in the molten material and having an upper surface arranged at such a depth below the local free surface that laminar flow prevails. The upper surface may be plane and horizontal, or it may be conical; and ducts may be defined through the member for the flow therethrough of the molten material to emerge on the upper surface of the member.

In the previously known method of pulling a silicon crystal the molten material immediately below the crystal tends to cool and a convection current is set up in the molten material, whereas use of the method and the apparatus of the invention reduces the flows due to natural convection within the molten material in the vicinity of the free surface from which the crystal is pulled. Consequently it enables crystals to be grown with fewer thermal stresses and a more homogeneous distribution of impurities than those grown by the known method.

The invention will now be further described by way of example only and with reference to the accompanying drawings, in which:

Figure 1 shows a diagrammatic medial sectional view in a vertical plane of a crystal pulling apparatus;

Figure 2 shows a diagrammatic medial sectional view in a vertical plane of part of an alternative crystal pulling apparatus; and

Figure 3 shows a modification to the apparatus of Figure 2.

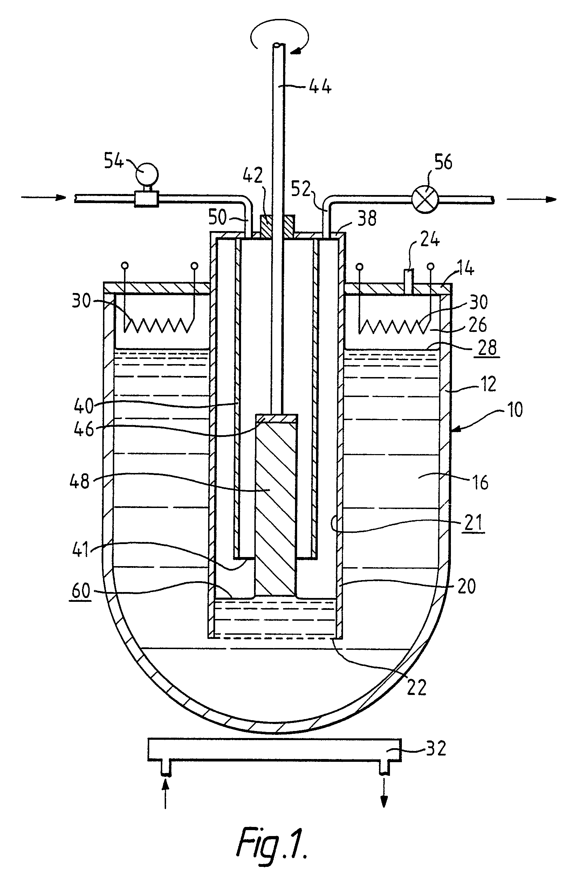

Referring to Figure 1, a crystal pulling apparatus 10 comprises a silica crucible 12 with a silica lid 14, and containing molten silicon 16 at a temperature somewhat above its melting point of 1414°C. A pressure tube 20 of silica defining a bore 21 is supported centrally within the crucible 12 by the lid 14 and extends downwards through the molten silicon 16, with an open end 22 near the bottom of the crucible 12. An inert gas (e.g. argon) is supplied at about atmospheric pressure through a port 24 in the lid 14 to an annular space 26 around the pressure tube 20 defined between the free surface 28 of the molten silicon 16 and the lid 14. Radiant electric heaters 30 (only two are shown) are supported by the lid 14 within the annular space 26, and are arranged to supply heat substantially uniformly across the free surface 28.

A cooler 32 is located below the crucible 12, through which a coolant fluid (e.g. water) may be passed.

The upper end of the pressure tube 20 is closed by an end portion 38 which supports both a concentric silica shroud tube 40, open at its lower end 41, and also a centrally located gas tight rotary seal 42 through which passes a shaft 44 extending along the longitudinal axis of the pressure tube 20. At the lower end of the shaft 44 is a disk 46 to support, in operation, a single crystal 48 of solid silicon. An inlet duct 50 through the end portion 38 of the pressure tube 20 enables an inert gas (e.g. argon) to be introduced into the shroud tube 40 at such a pressure as to depress the free surface 60 of the molten silicon 16 within the bore 21 of the pressure tube 20 to a level below the lower end 41 of the shroud tube 40, as shown. A pressure regulator 54 controls the pressure of the gas flowing into the shroud tube 40 through the inlet duct 50, the gas then flowing down the shroud tube 40, and up between the shroud tube 40 and the pressure tube 20, and so out of an outlet duct 52 in the end portion 38 of the pressure tube 20, its rate of flow being controlled by an adjustable valve 56.

In operation of the crystal pulling apparatus 10, the silicon 16 is maintained in a molten state by the electric heaters 30, heat being transferred by conduction in the molten silicon 16 from the uppermost layers to the bottom. To achieve a uniform and steady temperature gradient it may be desirable to pass a coolant fluid through the cooler 32, but not such as to cause solidification of the silicon 16. The pressure of the inert gas within the bore 21 is controlled by the pressure regulator 54 to maintain the free surface 60 at a level below the lower end 41 of the shroud tube 40 and above the open end 22 of the pressure tube 20. When sufficient time has elapsed for the temperature gradient to be uniform and for all convective flows to have stopped, the shaft 44 is lowered until the disk 46 touches the depressed free surface 60 of the molten silicon, and the shaft 44 is then gradually raised while rotating at about 20 r.p.m or less. The single crystal 48 of silicon grows below the disk 46, and is cooled by heat conduction up the shaft 44 and by the gas flowing down the shroud tube 40.

The shroud tube 40 shields to some extent the crystal 48 from heat radiation emitted by the hot walls of the pressure tube 20, and the rate of flow of gas down the shroud tube 40 may be adjusted by means of the valve 56 to achieve a desired rate of cooling of the crystal 48.

It will be appreciated that the crystal pulling apparatus 10 may be used to pull single crystals of materials other than silicon, and that in some cases it may be desirable to provide an insulating layer (not shown) around the sides of the crucible 12 to minimise heat losses from the sides. Whether the crystal pulling apparatus is to be used for pulling crystals of silicon or of another metallic or non-metallic material, the crucible 12, the pressure tube 20 and the shroud tube 40 may be of any suitable alternative material.

It will be understood that the shroud tube 40 might in some circumstances be dispensed with, and that in some circumstances it might not be necessary for the gas to flow over the surface of the crystal 48. The radiant heaters 30 might be replaced by heaters around the side at the top of the crucible 12, as long as the crucible 12 is sufficiently tall that the variations in temperature across any horizontal plane within the molten material are insignificant in the lower part of the crucible 12. Furthermore, the heat might be supplied by R.F. Heating.

If desired, the method might be operated on a continuous basis, fresh hot molten material being supplied at the top of the crucible 12 into the annular region 26 at the same rate that molten material is removed from the free surface 60 by the pulling of the crystal 48. In this case of course the fresh molten material could provide at least part of the heat otherwise provided by the radiant heaters 30. The fresh molten material should be hotter than the molten material already in the crucible 12 so that it floats thereon, and should be introduced uniformly around the annular region 26 so as to retain a symmetrical temperature distribution within the crucible 12 and minimise the temperature differences in any horizontal plane within the molten material.

The shaft 44 has been described as rotating at about 20 r.p.m. during the growing of the crystal 48, but it will be appreciated that a different rate of rotation might be used, and that the rate of rotation might be varied during the operation of the method.

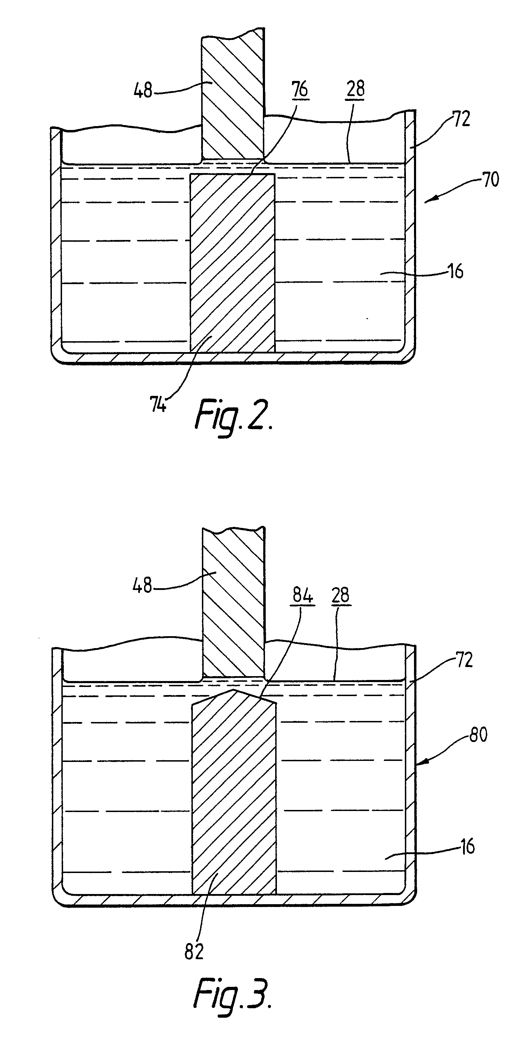

Referring now to Figure 2, part of an alternative crystal pulling apparatus 70 is shown, comprising a silica crucible 72 containing molten silicon 16 at a temperature somewhat above its melting point. As in the apparatus 10 of Figure 1, the silicon 16 is heated uniformly across its free surface 28 by radiant heaters (not shown in Figure 2). Means (not shown) are provided above the crucible 72 for raising and rotating a cylindrical crystal 48 of silicon, whose lower end is held just in contact with the free surface 28 of the molten silicon 16; the crystal 48 is raised at the same rate as it grows by solidification of the molten silicon 16, the latent heat being dissipated primarily by conduction up the crystal 48.

Immersed in the molten silicon 16 is a solid right-cylindrical silica spigot 74 mounted onto the base of the crucible 72, with a plane upper surface 76 arranged to be 3mm below the free surface 28 of the molten silicon 16. The diameter of the spigot 74 is slightly greater than that of the crystal 48, with which it is coaxial.

In operation of the apparatus 70, turbulence within the molten silicon 16 immediately below the crystal 48 is suppressed, as the gap between the upper surface 76 of the spigot 74 and the lower end of the crystal 48 is too narrow to permit the development of turbulence.

It will be appreciated that the spigot 74 might have a non-planar upper surface, and referring now to Figure 3, there is shown a crystal pulling apparatus 80 differing from that of Figure 2 only in having a spigot 82 with a conical upper surface 84 whose apex is 2mm below the free surface 28 of the molten silicon 16 and whose perimeter is 5mm below the free surface 28 of the molten silicon 16. The apparatus 80 operates in the same manner to the apparatus 70, turbulent flow being suppressed by the narrowness of the gap between the spigot 82 and the crystal 48.

It will be appreciated that the diameter of the spigot 74 or 82, the depth below the free surface 28 of the molten silicon 16 of the top 76, 84 of the spigot, and the angle of the conical surface 84 (if applicable), should be chosen so as to minimise turbulence while permitting laminar flow in the gap below the crystal 48, and that the optimum values therefore depend upon the physical properties (density, expansivity and viscosity) of the molten silicon 16. It will also be appreciated that the spigot 74 or 82 might be hollow to reduce the thermal stresses in it.

## Claims

1. A method for pulling a single crystal (48) from molten material (16) in a container (12), characterised in that the molten material is heated at or near the top thereof, the crystal (48) is pulled from a local free surface (60) of the molten material, and turbulent flow of the molten material is suppressed in the region of the local free surface (60).

2. A method as claimed in Claim 1 wherein turbulent flow is suppressed by arranging the local free surface (60) to be well below the free surface (28) of the molten material in the container (12).

3. A method as claimed in Claim 1 wherein turbulent flow is suppressed by arranging the depth of molten material below the local free surface to be sufficiently small that laminar flow prevails.

4. An apparatus for pulling a single crystal (48) from molten material (16), the apparatus comprising, a container (12) for the molten material, heating means (30), and pulling means (44, 46) for pulling a crystal from a local free surface of the molten material, characterised in that the heating means is at the upper portion of the container and by means (20, 50; 74; 82) for suppressing turbulent flow in the molten material below the local free surface (60, 28).

5. An apparatus as claimed in Claim 4 wherein the suppressing means comprises a member (20) defining an elongate chamber (21) arranged to extend substantially vertically and having an opening (22) to provide communication for the molten material between the chamber (21) and the container (12) below the upper portion of the container, and pressure means (50) for depressing the free surface (60) of the molten material within the chamber (21) well below the level of the free surface (28) of the molten material in the container (12), the pulling means (44, 46) being arranged to pull a crystal (48) from the depressed free surface (60).

6. An apparatus as claimed in Claim 5 including a radiant heater (30) to heat the molten material across the upper surface thereof, and means (32) to cool the molten material at the bottom portion of the container.

7. An apparatus as claimed in Claim 5 or Claim 6 wherein the chamber is defined by a tube (20) extending into the container and having an open lower end (22) near the bottom portion of the container (12).

8. An apparatus as claimed in any one of Claims 5 to 7 also including a shroud member (40) within the chamber to protect at least in part the crystal (48) being pulled from heat radiation from the walls of the chamber.

9. An apparatus as claimed in Claim 8 wherein the pressure means comprises means (54, 50) for supplying pressurised gas to the chamber (21), to flow through the chamber (21), arranged so that the gas flows downwardly inside the shroud member (40) over the surface of the crystal (48) being pulled, and upwardly between the shroud (40) and the walls of the chamber (21).

10. An apparatus as claimed in Claim 4 wherein the suppressing means comprises a member (74, 82) arranged so as to be immersed in the molten material (16) and having an upper surface (76, 84) arranged at such a depth below the local free surface (28) that laminar flow prevails.

*Fig.1.*

Fig.2.

Fig.3.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | NL-A- 238 924 (N.V. PHILIPS GLOEILAMPENFABRIEKEN) * Page 2, lines 21-27; page 3, lines 1-11; figures 1,2 * | 1,3,10 | C 30 B 15/12 |
| X | EP-A-0 124 938 (N.V. PHILIPS GLOEILAMPENFABRIEKEN) * Page 2, lines 22-38; page 3, lines 1-5; figures 1-3 * | 1 | |
| X | JP-A-62 138 392 (HITACHI CABLE LTD)(22-06-1987) * Whole abstract * & PATENT ABSTRACTS OF JAPAN, vol. 11, no. 365 (C-460)[2812], 27th November 1987 | 1,2 | |
| X | EP-A-0 170 856 (GENERAL SIGNAL CORP.) * Page 6, line 34 - page 7, line 32 * | 1 | |
| A | DE-A-1 913 682 (SIEMENS AG) | | |
| X | N.T.I.S. TECH NOTES, October 1986, page 1115, Springfield, VA, US; R. RICHTER: "Crystal-growing crucible to suppress convection" * Whole article * | 1,3,10 | **TECHNICAL FIELDS SEARCHED (Int. Cl.4)** C 30 B |

The present search report has been drawn up for all claims

| Place of search | Date of completion of the search | Examiner |
|---|---|---|
| THE HAGUE | 14-11-1988 | COOK S.D. |